Europäisches Patentamt

European Patent Office

Office européen des brevets

(11) Publication number: **0 130 793 B1**

(19)

(12) **EUROPEAN PATENT SPECIFICATION**

(45) Date of publication of patent specification: **03.03.93**   (51) Int. Cl.⁵: **G11C 8/00**, G11C 5/06

(21) Application number: **84304379.5**

(22) Date of filing: **28.06.84**

(54) **Semiconductor memory device.**

(30) Priority: **29.06.83 JP 115881/83**

(43) Date of publication of application:
**09.01.85 Bulletin  85/02**

(45) Publication of the grant of the patent:
**03.03.93 Bulletin  93/09**

(84) Designated Contracting States:
**DE FR GB**

(56) References cited:
**EP-A- 0 011 448**
**EP-A- 0 019 241**
**EP-A- 0 025 316**
**US-A- 3 695 855**

**PATENT ABSTRACTS OF JAPAN, vol. 7, no.
23 (P-171)[1168], 29th January 1983; & JP-
A-57 176 590 (RICOH K.K.) 29-10-1982**

**PATENT ABSTRACTS OF JAPAN, vol. 6, no.
233 (P-156)[1111], 19th November 1982; & JP-
A-57 133 586 (NIPPON DENSHIN DENWA
KOSHA) 18-08-1982**

**A.B.Grebene, "Bipolar and MOS analog in-
tegrated circuit design", John Wiley & Sons,
1984, p. 197-203**

(73) Proprietor: **FUJITSU LIMITED**
**1015, Kamikodanaka Nakahara-ku
Kawasaki-shi Kanagawa 211(JP)**

(72) Inventor: **Nakajima, Tetsuya**
**2468, Nagatsuda-cho Midori-ku
Yokohama-shi Kanagawa 227(JP)**
Inventor: **Nagahara, Masaki**
**1118, Kamikodanaka Nakahara-ku
Kawasaki-shi Kanagawa 211(JP)**

(74) Representative: **Sunderland, James Harry et al
HASELTINE LAKE & CO Hazlitt House 28
Southampton Buildings Chancery Lane
London WC2A 1AT (GB)**

R. Irvine, "Operational amplifier characteristics and applications", Prentice-Hall, 1981, p. 21-24

H-M. Rein et al., "Integrierte Bipolarschaltungen",Springer-Verlag, 1980, p. 46-48

M.I. Elmasry, "Digital bipolar integrated circuits", John Wiley &Sons, 1983, p. 192-197 and 201

S.M.Sze, "Semiconductor Devices, Physics and Technology", Bell Telephone Laboratories, 1985, page 376

## Description

The present invention relates to a semiconductor memory device (below, "memory"), more particularly to a memory of a static random access memory (S.RAM) type composed of emitter-coupled-logic (ECL) memory cells.

Various types of memories have been developed and put into practical use. Recent research and development has concentrated upon achieving greater miniaturization of memory patterns, i.e., increasingly higher densities of packing of integrated circuit (IC) memories. To fabricate a denser IC memory, however, it is not sufficient merely to miniaturize the memory cells and wiring. Miniaturization creates additional problems which themselves must be solved.

In a prior art ECL-type S.RAM, increased miniaturization and high integration create the problem of electromigration. More specifically, when the current density exceeds a predetermined threshold level in, for example, aluminium wiring made narrower in width by miniaturization, the inherently solid-state aluminium is transformed by heat into a molten state and will flow elsewhere.

When electromigration takes place, the functioning of the memory cannot be guaranteed. Therefore, excessive current density must be prevented, not only for aluminium wiring but for all other wiring of other conductive materials, so as to suppress electromigration.

According to the present invention there is provided a semiconductor memory device, operatively connected to a word decoder which generates a word selection signal at a memory selection time, said memory device comprising:-

a plurality of memory cells, each of said memory cells comprising a pair of bipolar transistors cross-coupled to form a flip-flop;

a plurality of initial word drivers, each operatively connected to the word decoder and activated by the word selection signal from the word decoder;

a plurality of bit line pairs operatively connected to said memory cells;

a plurality of bit drivers, each operatively and respectively connected to one of said bit line pairs, for sending a bit line selection signal thereto, thereby specifying a desired one of said memory cells in combination with the word selection signal;

a plurality of word lines, operatively and respectively connected to said initial word drivers and said memory cells, forming cross points with said bit line pairs, said memory cells being located at the cross points; characterised by:-

said word lines being made out of a material in which electromigration may occur and each being divided into a plurality of word line segments, a first word line segment of each of said word lines being directly activated to carry a word line signal by one of said initial word drivers in dependence upon the word selection signal;

segment word drivers operatively connected between the word line segments, one of said segment word drivers being activated when the word selection signal activates a corresponding initial word driver operatively connected via a corresponding first word line segment to the one of said segment word drivers, each of said segment word drivers being formed by a single emitter follower transistor operatively connected to a following second word line segment and having a base operatively connected to the corresponding first word line segment; and

a plurality of level shifting means, provided respectively for ones of said bit drivers connected to bit line pairs corresponding to said second word line segments, and each operable to lower the level of the bit line selection signal of the respective bit driver relative to the bit line selection signals of ones of said bit drivers connected to bit line pairs corresponding to said first word line segments.

An embodiment of the present invention can provide a semiconductor memory device, particularly an ECL-type S•RAM, which can reduce the current density in wiring, even narrow-width wiring used in miniaturized memories.

Consideration is given to reducing the current density of all word lines of a memory since there is considerable likelihood of electromigration in word lines due to their inherent roles. Each word line is divided into a plurality of segmented word lines. Each segmented word line is connected to an individual word driver and provided with memory cells, etc. Each of the segmented word lines carries an individual word current from an individual word driver when the word line is rendered to be in a selection state.

EP-A 0 025 316 discloses a semiconductor memory device in accordance with the preambuler portion of claim 1. Reference is made, by way of example, to the accompanying drawings, wherein :

Fig. 1 is a circuit diagram representing part of a typical semiconductor memory device;

Fig. 2A is a partial view of a semiconductor memory device equivalent to that of Fig. 1, but drawn somewhat simpler;

Fig. 2B is a diagram depicting the distribution of current density in and along a word line of Fig. 2A;

Fig. 3 is a general view of a semiconductor memory device according to the present invention, taking an arbitrary word line as an example;

Fig. 4A is a circuit diagram of a part of a semiconductor memory device according to an embodiment of the present invention;

Fig. 4B is a diagram depicting the distribution of current density in and along the word line segments of Fig. 4A;

Fig. 5 illustrates a detailed example of a known memory cell in Fig. 1; and

Fig. 6 is a more detailed circuit diagram of the semiconductor memory device based on the device shown in Fig. 4A .

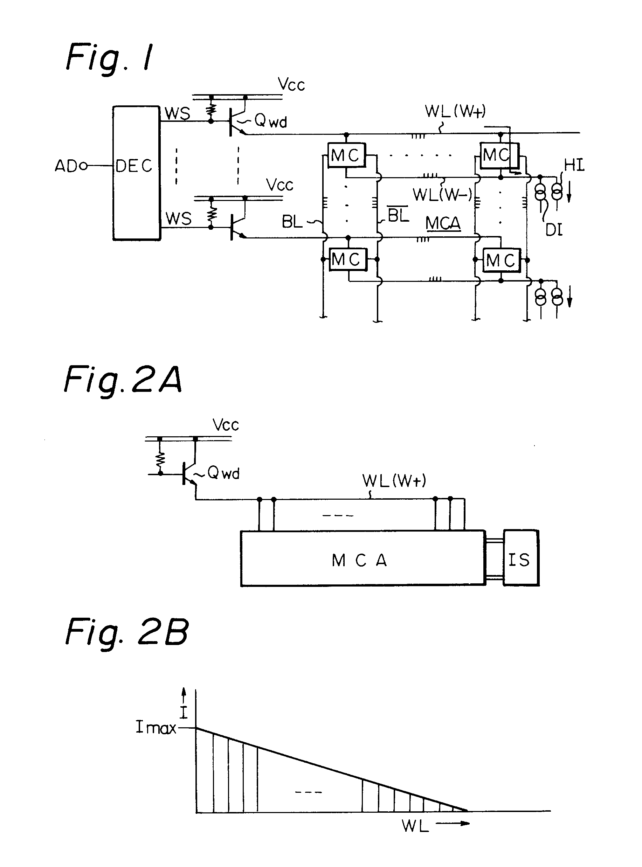

Figure 1 is a circuit diagram representing a part of a typical semiconductor memory device. The memory shown in Fig. 1 is specifically an ECL-type S•RAM. In Fig. 1, reference characters MC indicate memory cells which cooperate with a word line pair WL. Each pair WL is comprised of word lines W+ and W−. Many identical sets of word line pairs WL and memory cells MC are arranged in the direction along which bit line pairs (BL, $\overline{BL}$) extend. Thus, many memory cells MC are located at cross points of the word lines and the bit line pairs. These memory cells MC constitute a memory cell array, indicated by MCA.

In a usual S•RAM, each word line W− is arranged with a respective word line W+ as a pair. Each pair of these word lines W+ and W− is connected to an individual hold current source HI. The hold current of each source HI enables the maintenance of a logic "1" or "0"/state stored in each memory cell MC. Each word line W+ is selected by a corresponding word selection signal WS given by a word decoder DEC in accordance with an address input AD. The selection is achieved by turning on an individual word driver $Q_{wd}$ connected to the word line W+ at one end. On the other hand, similar drivers, i.e., bit drivers (mentioned hereinafter) are provided for respective bit line pairs BL, $\overline{BL}$, in the memory.

In a circuit of the Fig.1 type with high integration, there is significant electromogration in the word lines W+. A considerably large current may flow through each word line W+ due to, first, the hold current continually supplied to all the memory cells MC of each word line W+ and, second, a discharge current led to each discharge current source (DI) every time the word line pair WL is selected. In other words, the aforesaid large current along the word line W + is the sum of the hold current ($I_h$) and the discharge current ($I_d$) and is generated every time the word line W+ is in a selected state. It should be noted that of the various types of memories, a bipolar ECL-type S•RAM exhibits the largest $I_h$ and $I_d$ currents.

Incidentally, as is well known, the discharge current is useful to effect a quick change from the selection state to the nonselection state.

Figure 2A is a partial view of a semiconductor memory device equivalent to that of Fig. 1, but drawn somewhat more simply. Figure 2B is a diagram depicting the distribution of current density in and along the word line WL of Fig. 2A. The memory cell array MCA of Fig. 1 is represented simply as a block "MCA" in Fig. 2A. Also, the hold current source HI and the discharge current source DI are represented simply as a block(current source)"IS" in Fig. 2A. In Fig. 2B, the abscissa denotes positions along the word line WL of Fig. 2A, and the ordinate denotes a current I flowing therethrough. As shown in Figs. 2A and 2B, the peak current density is $I_{max}$ , which is produced at a current supply side of the word line, i.e., the end of the word line to which the word driver $Q_{wd}$ is connected.

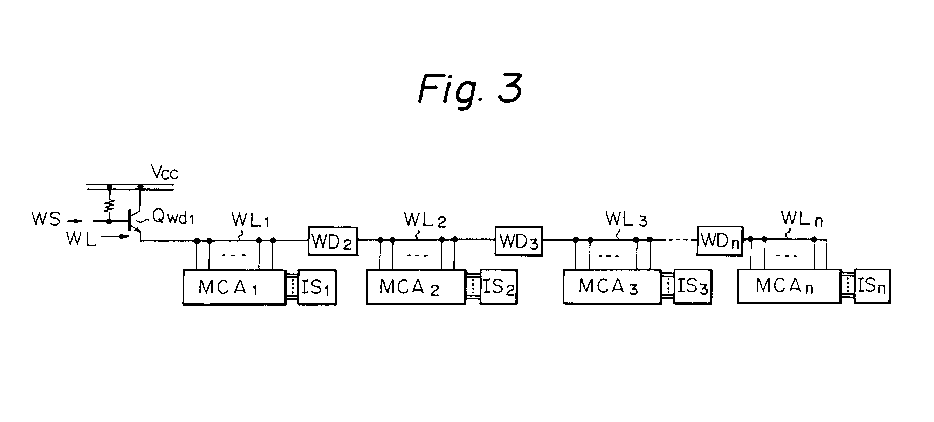

Figure 3 is a general view of a semiconductor memory device according to the present invention, taking an arbitrary word line as an example. As seen from Fig. 3, the word line WL is divided to form, along its length, a plurality of segmented word lines. Each of the word line segments $WL_1$ , $WL_2$ , $WL_3$ ... $WL_n$ , except for the first segment $WL_1$ activated directly by the word driver $Q_{wd1}$ , is provided with an individual private word driver, i.e., $WD_2$ , $WD_3$ ... $WD_n$ . When a word selection signal WS is given to supply a current individually to the memory cells in $MCA_1$ for the word line segment $WL_1$ , the first private word driver $WD_2$ is operated in response to the word line signal appearing at the first word line segment $WL_1$. At the same time, the second and following private word drivers $WD_3$ ... $WD_n$ are operated in response to the word line signals appearing at preceding word line segments $WL_2$ , $WL_3$ ... $WL_{(n-1)}$ (not shown), respectively. In this regard, the memory cell array MCA and the drive current source IS, both shown in Fig. 2A, are segmented as $MCA_1$ , $IS_1$; $MCA_2$ , $IS_2$; $MCA_3$ , $IS_3$; and so on.

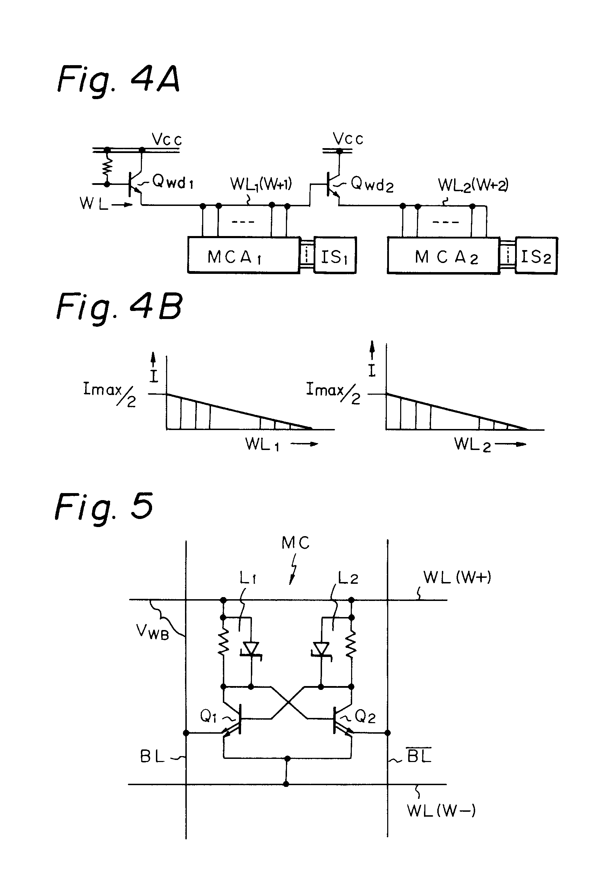

Figure 4A is a circuit diagram of part of a semiconductor memory device according to an embodiment of the present invention. Figure 4B is a diagram depicting the distribution of current density in and along the word line segments of Fig. 4A.

The explanation of Figs. 4A and 4B will, for simplicity, be made taking as an example a case where the memory is segmented into two blocks. That is, a word line WL is divided to form first and second word line segments $WL_1$ and $WL_2$. Therefore, the memory cells and the current source are also segmented to form $MCA_1$ , $IS_1$ and $MCA_2$ , $IS_2$. In a first block, the word driver $Q_{wd1}$ is connected to the first word line segment $WL_1$. The word driver $WD_2$ of Fig. 3 is specifically comprised of a word driver $Q_{wd2}$. Other word drivers $WD_3$ ... $WD_n$ of Fig. 3 have identical constructions to that of the word driver $WD_2$ shown in Fig. 4A, i.e., a single transistor. In the example of Fig. 4A, the distribution of current density is as shown in Fig. 4B. It is important to note that the peak current density in each of the word line segments $WL_1$ and $WL_2$ is

approximately halved to $I_{max/2}$ , the value $I_{max}$ being that obtained in the prior art circuit of Figs.2A and 2B.

According to this embodiment of the invention,the word driver transistor $Q_{wd2}$ is directly connected, at its base, to the preceding word line segment, i.e., $WL_1$ , so as to activate the transistor $Q_{wd2}$ in response to the word selection signal WS. That is, when the signal WS is given to the word driver $Q_{wd1}$ , the word line signal appears with an "H" (high) level at the segment $WL_1$. The "H" level signal is transferred, via the transistor $Q_{wd2}$ , to the following word line segment, i.e., $WL_2$. Thus, the whole corresponding word line WL is selected. The above construction has the advantage that no separate control line is needed to activate the word driver transistor $Q_{wd2}$.

Referring to Fig. 4A, the word line WL is segmented into $WL_1$ and $WL_2$ using the word driver transistor $Q_{wd2}$. Therefore, in this case, the voltage level at the word line segment $WL_2$ is lowered by $V_{BE}$ from that of the word line segment $WL_1$ , where $V_{BE}$ denotes a base-emitter voltage of the word driver transistor $Q_{wd2}$. This lowering of the voltage of the segment $WL_2$ has a deleterious effect on the operation of the memory cell array $MCA_2$. This will be further explained with reference to Fig. 5.

Figure 5 illustrates a detailed example of the known memory cell MC in Fig. 1. As seen from Fig. 5, each memory cell MC is comprised of multiemitter transistors $Q_1$ and $Q_2$ and loads $L_1$ and $L_2$. Each of the loads is constituted by both a resistor and a Schottky barrier diode connected in parallel. Assuming here that the transistor $Q_1$ is now on(the same explanation is similar when transistor $Q_2$ is on), the voltage difference $V_{WB}$ between the word line W+ and the bit line BL must be higher than a predetermined level so as to maintain the transistor $Q_1$ conductive during the selection state of the corresponding word line. This predetermined level,$V_{WB}$, mentioned above is equal to the sum of a voltage drop across the load $L_2$ and the base-emitter voltage of the transistor $Q_1$. Even though the predetermined level $V_{WB}$ is assured for the selected memory cell MC in the first memory cell array $MCA_1$ , it is not assured for the second memory cell array $MCA_2$. This is because the level $V_{WB}$ is lowered to $V'_{WB}$ expressed as $V'_{WB} = V_{WB} - V_{BE}$ , where $V_{BE}$ denotes the aforesaid base-emitter voltage of the word driver transistor $Q_{wd2}$.In this case, an output voltage of each bit driver (mentioned hereinafter) is increased relative to the lowering of $V_{WB}$ , which output voltage is used to determine the voltage of the bit line BL. Due to the relative increase of the output voltage, a bit line driver transistor (mentioned hereinafter) is saturated. Under the saturation state, the read operation speed is reduced. To counter this, in an embodiment of the present invention, a level shifting means is employed in each of the bit drivers cooperating with the memory cell array $MCA_2$. This also applies to other bit drivers cooperating with the memory cell arrays $MCA_3$ ... $MCA_n$ following thereafter. Thus, the voltage $V'_{WB}$ (= $V_{WB}$ - $V_{BE}$) is shifted upward in level by $V_{BE}$. The aforesaid voltage difference $V_{WB}$ obtained in the memory cell array $MCA_1$ can thereby also be assured in the memory cell array $MCA_2$.

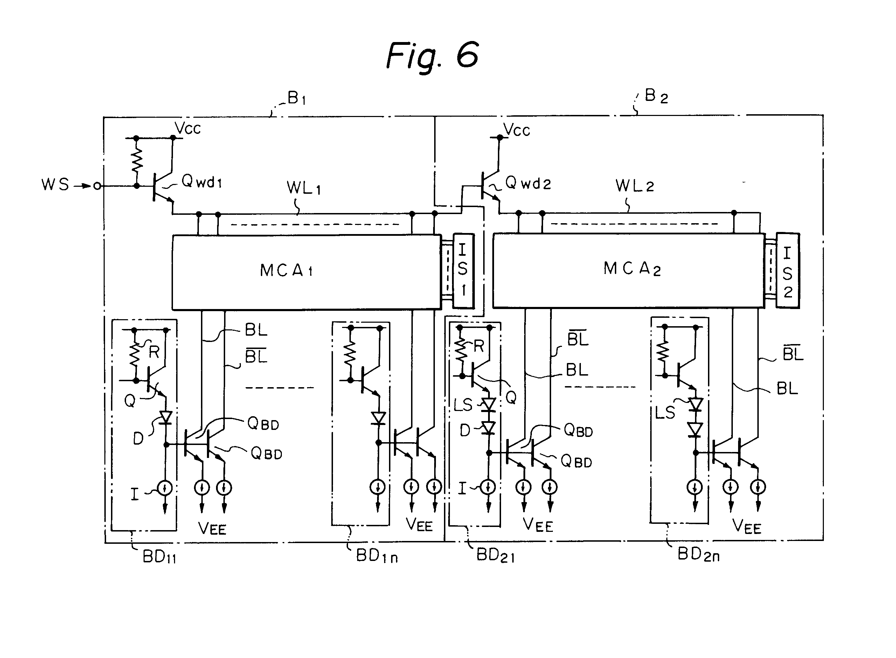

Figure 6 is a more detailed circuit diagram of a semiconductor memory device based on the device shown in Fig. 4A. In Fig. 6, the bit drivers are specifically illustrated with reference characters $BD_{11}$ through $BD_{21}$ through $BD_{2n}$. The bit driver transistors in each of the bit drivers are specifically illustrated with reference characters $Q_{BD}$. The level shifting means is represented by reference characters LS in the block $B_2$ containing the second Memory cell array $MCA_2$. It should be understood that only two blocks $B_1$ and $B_2$ are illustrated for simplicity and to conform to the example of Fig. 4A. In the first block $B_1$ , each of the first bit drivers $BD_{11}$ through $BD_{1n}$ is constructed by a resistor R, transistor Q, diode D, and a constant current source I. These components are also used in each bit driver in the second block $B_2$.

In the second block $B_2$ , as previously mentioned, the bit line voltage has a voltage difference of $V'_{WB}$ (= $V_{WB}$ - $V_{BE}$) relative to the word line voltage. The thus lowered voltage $V'_{WB}$ must be restored to the nominal voltage $V_{WB}$ , as provided in the first block $B_1$. For this, a level shift means LS is employed. in each bit driver. The level shift means LS can be realized by diodes, as exemplified in the bit drivers $BD_{21}$ through $B_{2n}$. As is well known, diodes inherently function to shift the voltage level by an amount such as $V_{BE}$. Therefore, the bit line level can be lowered by $V_{BE}$ with the use of the diode LS, and the voltage difference $V'_{WB}$ can be increased to $V_{WB}$. In this regard, it will be apparent that, in a third block ($B_3$), which is not shown but may follow the block $B_2$ , a similar level shifting means LS should be constituted by two diodes connected in series for producing a shift level of about 2 $V_{BE}$.

As explained above in detail, according to the present invention, the current density in each word line can be considerably reduced. Therefore, the width of each word line can be narrowed further. This enables further miniaturization of an IC memory. It should be noted that the introduction of the individual private word drivers and the buffer gate circuits ($BG_1$ or $BG_2$) into the IC memory does not obstruct miniaturization because the word lines usually extend in the IC memory with a considerably large length and considerable space can be saved when reducing the widths of such lengthy word lines. The thus saved space is enough to accommodate the word drivers and the buffer gate circuits.

## Claims

1. A semiconductor memory device, operatively connected to a word decoder (DEC) which generates a word selection signal (WS) at a memory selection time, said memory device comprising:-

   a plurality of memory cells (MC), each of said memory cells comprising a pair of bipolar transistors ($Q_1$, $Q_2$) cross-coupled to form a flip-flop;

   a plurality of initial word drivers ($Q_{wd1}$), each operatively connected to the word decoder (DEC) and activated by the word selection signal (WS) from the word decoder;

   a plurality of bit line pairs (BL, $\overline{BL}$) operatively connected to said memory cells (MC);

   a plurality of bit drivers ($BD_{11}$, ... $BD_{2n}$)-,each operatively and respectively connected to one of said bit line pairs (BL, $\overline{BL}$), for sending a bit line selection signal thereto, thereby specifying a desired one of said memory cells (MC) in combination with the word selection signal (WS);

   a plurality of word lines (WL), operatively and respectively connected to said initial word drivers ($Q_{wd1}$) and said memory cells (MC), forming cross points with said bit line pairs (BL, $\overline{BL}$), said memory cells (MC) being located at the cross points; characterised by:-

   said word lines (WL) being made out of a material in which electromigration may occur and each being divided into a plurality of word line segments ($WL_1$, $WL_2$), a first word line segment ($WL_1$) of each of said word lines being directly activated to carry a word line signal by one of said initial word drivers ($Q_{wd1}$) in dependence upon the word selection signal (WS);

   segment word drivers ($Q_{wd2}$) operatively connected between the word line segments ($WL_1$, $WL_2$), one of said segment word drivers ($Q_{wd2}$) being activated when the word selection signal (WS) activates a corresponding initial word driver ($Q_{wd1}$) operatively connected via a corresponding first word line segment ($WL_1$) to the one of said segment word drivers ($Q_{wd2}$)-,each of said segment word drivers being formed by a single emitter follower transistor operatively connected to a following second word line segment ($WL_2$) and having a base operatively connected to the corresponding first word line segment ($WL_1$); and

   a plurality of level shifting means (LS), provided respectively for ones of said bit drivers ($BD_{21}...BD_{2n}$) connected to bit line pairs (BL, $\overline{BL}$) corresponding to said second word line segments ($WL_2$), and each operable to lower the level of the bit line selection signal of the respective bit driver relative to the bit line selection signals of ones of said bit drivers ($BD_{11}$ .... $BD_{1n}$) connected to bit line pairs corresponding to said first word line segments (WL1).

2. A device as set forth in claim 1, wherein each of said level shifting means (LS) provided for bit drivers ($BD_{21}...BD_{2n}$) connected to bit line pairs crossing the second word line segments ($WL_2$) immediately following the first word line segments, comprises a single diode.

3. A device as set forth in claim 2, wherein each of said bit drivers ($BD_{21}...BD_{2n}$) including one of said level shifting means further includes a first bit driver transistor ($Q_{BD}$) operatively connected to one bit line pair in said bit line pairs crossing the second word line segments and having a base operatively connected to said diode in said level shifting means (LS) included therein.

4. A semiconductor memory device as set forth in claim 1,2, or 3,

   wherein the emitter follower transistor ($Q_{wd1}$) of each first segment word driver has a base operatively connected to receive the word selection signal (WS) and an emitter operatively connected to the first segment ($WL_1$) of the one of the word lines, and

   wherein the emitter follower transistor ($Q_{wd2}$) of each second segment word driver has a base operatively connected to the first segment ($WL_1$) of the respective word line and an emitter operatively connected to the second segment ($WL_2$) of the respective word line.

## Patentansprüche

1. Halbleiterspeicheranordnung, die funktionsmäßig mit einem Wortdecodierer (DEC) verbunden ist, welcher ein Wortauswahlsignal (WS) zu einer Speicherauswahlzeit erzeugt, welche Speicheranordnung umfaßt: -

   eine Vielzahl von Speicherzellen (MC), wobei jede der Speicherzellen ein Paar von Bipolartransistoren ($Q_1$, $Q_2$) umfaßt, die kreuzgekoppelt sind, um einen Flip-Flop zu bilden;

   eine Vielzahl von Initialworttreibern ($Q_{wd1}$), von denen jeder funktionsmäßig mit dem Wortdecodierer (DEC) verbunden ist und durch das Wortauswahlsignal (WS) aus dem Wortdecodierer aktiviert wird;

eine Vielzahl von Bitleitungspaaren (BL, $\overline{BL}$), die funktionsmäßig mit den Speicherzellen (MC) verbunden sind;

eine Vielzahl von Bittreibern (BD$_{11}$, ... BD$_{2n}$), von denen jeder funktionsmäßig jeweils mit einem der genannten Bitleitungspaare (BL, $\overline{BL}$) verbunden ist, um ihm ein Bitleitungsauswahlsignal zu senden, wodurch eine gewünschte der Speicherzellen (MC) in Kombination mit dem Wortauswahlsignal (WS) spezifiziert wird;

eine Vielzahl von Wortleitungen (WL), die funktionsmäßig jeweils verbunden sind mit den Initialworttreibern (Q$_{wd1}$) und den Speicherzellen (MC), wobei Kreuzungspunkte mit den Bitleitungspaaren (BL, $\overline{BL}$) gebildet sind, wobei die Speicherzellen (MC) an den Kreuzungspunkten angeordnet sind; dadurch gekennzeichnet, daß

die Wortleitungen (WL) aus einem Material gemacht sind, in welchem Elektromigration auftreten kann, und jeweils in eine Vielzahl von Wortleitungssegmenten (WL$_1$, WL$_2$) geteilt sind, wobei ein erstes Wortleitungssegment (WL$_1$) von jeder der Wortleitungen direkt aktiviert wird, um ein Wortleitungssignal durch einen der Initialworttreiber (Q$_{wd1}$) in Abhängigkeit vom Wortauswahlsignal (WS) zu übertragen; und gekennzeichnet durch

Segmentworttreiber (Q$_{wd2}$), die funktionsmäßig zwischen die Wortleitungssegmente (WL$_1$, WL$_2$) geschaltet sind, wobei einer der Segmentworttreiber (Q$_{wd2}$) aktiviert wird, wenn das Wortauswahlsignal (WS) einen entsprechenden Initialworttreiber (Q$_{wd1}$) aktiviert, der funktionsmäßig über ein entsprechendes erstes Wortleitungssegment (WL$_1$) mit einem der Segmentworttreiber (Q$_{wd2}$) verbunden ist, wobei jeder der Segmentworttreiber durch einen einzelnen Emitterfolgertransistor gebildet ist, welcher funktionsmäßig mit einem folgenden zweiten Wortleitungssegment (WL$_2$) verbunden ist und eine Basis besitzt, die funktionsmäßig mit dem entsprechenden ersten Wortleitungssegment (WL$_1$) verbunden ist; und

eine Vielzahl von Pegelschiebemitteln (LS), die jeweils für die einen der Bittreiber (BD$_{21}$,...BD$_{2n}$) vorgesehen sind, die mit den Bitleitungspaaren (BL, $\overline{BL}$), die den zweiten Wortleitungssegmenten (WL$_2$) entsprechen, verbunden sind, und jedes betreibbar ist, um den Pegel des Bitleitungsauswahlsignals des jeweiligen Bittreibers, relativ zu den Bitleitungsauswahlsignalen der einen der Bittreiber (BD$_{11}$...BD$_{1n}$), die mit Bitleitungspaaren verbunden sind, die den ersten Wortleitungsseg-

menten (WL$_1$) entsprechen, herabzusetzen.

2. Anordnung wie in Anspruch 1 ausgeführt, in der jedes der Pegelschiebemittel (LS), die für Bittreiber (BD$_{21}$...BD$_{2n}$) vorgesehen sind, die mit Bitleitungspaaren verbunden sind, die sich mit den zweiten Wortleitungssegmenten (WL$_2$) kreuzen, die den ersten Wortleitungssegmenten unmittelbar folgen, eine einzelne Diode umfaßt.

3. Anordnung wie in Anspruch 2 ausgeführt, in der jeder der Bittreiber (BD$_{21}$ ...BD$_{2n}$), der eines der Pegelschiebemittel enthält, ferner enthält einen ersten Bittreibertransistor (Q$_{BD}$), der funktionsmäßig mit einem Bitleitungspaar aus den Bitleitungspaaren verbunden ist, die die zweiten Wortleitungssegmente kreuzen, und der eine Basis besitzt, die funktionsmäßig mit der in den Pegelschiebemitteln (LS) enthaltenen Diode verbunden ist.

4. Halbleiterspeicheranordnung wie in Anspruch 1, 2 oder 3 ausgeführt,

worin der Emitterfolgertransistor (Q$_{wd1}$) des ersten Segmentworttreibers eine Basis besitzt, die funktionsmäßig verbunden ist, um das Wortauswahlsignal (WS) zu empfangen, und einen Emitter, der funktionsmäßig mit dem ersten Segment (WL$_1$) der einen der Wortleitungen verbunden ist, und

worin der Emitterfolgertransistor (Q$_{wd2}$) jedes zweiten Segmentworttreibers eine Basis besitzt, die funktionsmäßig mit dem ersten Segment (WL$_1$) der jeweiligen Wortleitung verbunden ist, und einen Emitter, der funktionsmäßig mit dem zweiten Segment (WL$_2$) der jeweiligen Wortleitung verbunden ist.

## Revendications

1. Dispositif de mémoire à semiconducteur connecté de façon opérationnelle à un décodeur de mot (DEC) qui génère un signal de sélection de mot (WS) à un instant de sélection de mémoire, ledit dispositif de mémoire comprenant :

une pluralité de cellules de mémoire (MC), chacune desdites cellules de mémoire comprenant une paire de transistors bipolaires (Q$_1$, Q$_2$) couplés en croix pour former une bascule ;

une pluralité de dispositifs de pilotage de mot initiaux (Q$_{wd1}$), chacun étant connecté de façon opérationnelle au décodeur de mot (DEC) et étant activé par le signal de sélection de mot (WS) en provenance du décodeur de mot ;

une pluralité de paires de lignes de bit

(BL, $\overline{BL}$) connectées de façon opérationnelle auxdites cellules de mémoire (MC) ;

une pluralité de dispositifs de pilotage de bit ($BD_{11}$, ..., $BD_{2n}$), chacun étant respectivement connecté de façon opérationnelle à l'une desdites paires de lignes de bit (BL, $\overline{BL}$) pour leur envoyer un signal de sélection de ligne de bit, d'où la spécification de l'une souhaitée desdites cellules de mémoire (MC) en combinaison avec le signal de sélection de mot (WS) ;

une pluralité de lignes de mot (WL) connectées respectivement et de façon opérationnelle auxdits dispositifs de pilotage de mot initiaux ($Q_{wd1}$) et auxdites cellules de mémoire (MC), qui forment des points de croisement avec lesdites paires de lignes de bit (BL, $\overline{BL}$), lesdites cellules de mémoire (MC) étant positionnées au niveau des points de croisement ;

caractérisé en ce que :

lesdites lignes de mot (WL) sont réalisées en un matériau dans lequel une électromigration peut se produire et chacune est divisée en une pluralité de segments de ligne de mot ($WL_1$, $WL_2$), un premier segment de ligne de mot ($WL_1$) de chacune desdites lignes de mot étant activé de façon directe pour transporter un signal de ligne de mot au moyen d'un desdits dispositifs de pilotage de mot initiaux ($Q_{wd1}$) en relation avec le signal de sélection de mot (WS) ;

des dispositifs de pilotage de mot de segment ($Q_{wd2}$) connectés de façon opérationnelle entre les segments de ligne de mot ($WL_1$, $WL_2$), l'un desdits dispositifs de pilotage de mot de segment ($Q_{wd2}$) étant activé lorsque le signal de sélection de mot (WS) active un dispositif de pilotage de mot initial correspondant ($Q_{wd1}$) connecté de façon opérationnelle via un premier segment de ligne de mot correspondant ($W_{L1}$) à l'un desdits dispositifs de pilotage de mot de segment ($Q_{wd2}$), chacun desdits dispositifs de pilotage de mot de segment étant formé par un unique transistor à émetteur suiveur connecté de façon opérationnelle à un second segment de ligne de mot suivant ($W_{L2}$) et comportant une base connectée de façon opérationnelle au premier segment de ligne de mot correpondant ($WL_1$) ; et

une pluralité de moyens de décalage de niveau (LS), prévus respectivement pour certains desdits dispositifs de pilotage de bit ($BD_{21}$,..., $BD_{2n}$) connectés à des paires de lignes de bit (BL, $\overline{BL}$) correspondant auxdits seconds segments de ligne de mot ($WL_2$) et chacun pouvant être actionné pour abaisser le niveau du signal de sélection de ligne de bit du dispositif de pilotage de bit respectif par rapport aux signaux de sélection de ligne de bit de certains desdits dispositifs de pilotage de bit ($BD_{11}$,..$BD_{1n}$) connectés à des paires de lignes de bit correspondant auxdits premiers segments de ligne de mot ($WL_1$).

2. Dispositif selon la revendication 1, dans lequel chacun desdits moyens de décalage de niveau (LS) prévu pour des dispositifs de pilotage de bit ($BD_{21}$,..., $BD_{2n}$) connectés à des paires de lignes de bit qui croisent les seconds segments de ligne de mot ($WL_2$) qui suivent immédiatement les premiers segments de ligne de mot comprend une unique diode.

3. Dispositif selon la revendication 2, dans lequel chacun desdits dispositifs de pilotage de bit ($BD_{21}$,..., $BD_{2n}$) incluant l'un desdits moyens de décalage de niveau inclut en outre un premier transistor de dispositif de pilotage de bit ($Q_{BD}$) connecté de façon opérationnelle à une paire de lignes de bit parmi lesdites paires de lignes de bit qui croisent les seconds segments de ligne de bit et qui comportent une base connectée de façon opérationnelle à ladite diode prévue dans ledit moyen de décalage de niveau (LS) inclus à l'intérieur.

4. Dispositif de mémoire à semiconducteur selon la revendication 1, 2 ou 3,

dans lequel le transistor à émetteur suiveur ($Q_{wd1}$) de chaque premier dispositif de pilotage de mot de segment comporte une base connectée de façon opérationnelle pour recevoir le signal de sélection de mots (WS) et un émetteur connecté de façon opérationnelle au premier segment ($WL_1$) de l'une des lignes de mot ; et

dans lequel le transistor à émetteur suiveur ($Q_{wd2}$) de chaque second dispositif de pilotage de mot de segment comporte une base connectée de façon opérationnelle au premier segment ($W_{L1}$) de la ligne de mot respective et un émetteur connecté de façon opérationnelle au second segment ($WL_2$) de la ligne de mot respective.

## Fig. 1

## Fig. 2A

## Fig. 2B

# Fig. 3

*Fig. 4A*

*Fig. 4B*

*Fig. 5*

Fig. 6

EP 0 130 793 B1